Europäisches Patentamt

(19) European Patent Office

Office européen des brevets

(11) Publication number: **0 136 568**
**A2**

# (12) EUROPEAN PATENT APPLICATION

(21) Application number: 84110420.1

(22) Date of filing: 01.09.84

(51) Int. Cl.⁴: **H 05 K 7/14**

(30) Priority: 06.09.83 US 529199

(43) Date of publication of application:
10.04.85 Bulletin 85/15

(84) Designated Contracting States:
DE GB IT NL SE

(71) Applicant: HONEYWELL INC.
Honeywell Plaza
Minneapolis Minnesota 55408(US)

(72) Inventor: Black, Robert A., Jr.
7007 Girard Avenue No.
Brooklyn Center, MN 55430(US)

(72) Inventor: Moenkhaus, Patrick R.
5132 Eastwood Road
Mounds View, MN 55112(US)

(74) Representative: Herzbach, Dieter et al,
Honeywell Europe S.A. Holding KG Patent- und
Lizenzabteilung Kaiserleistrasse 55 Postfach 184
D-6050 Offenbach am Main(DE)

(54) Electrical apparatus.

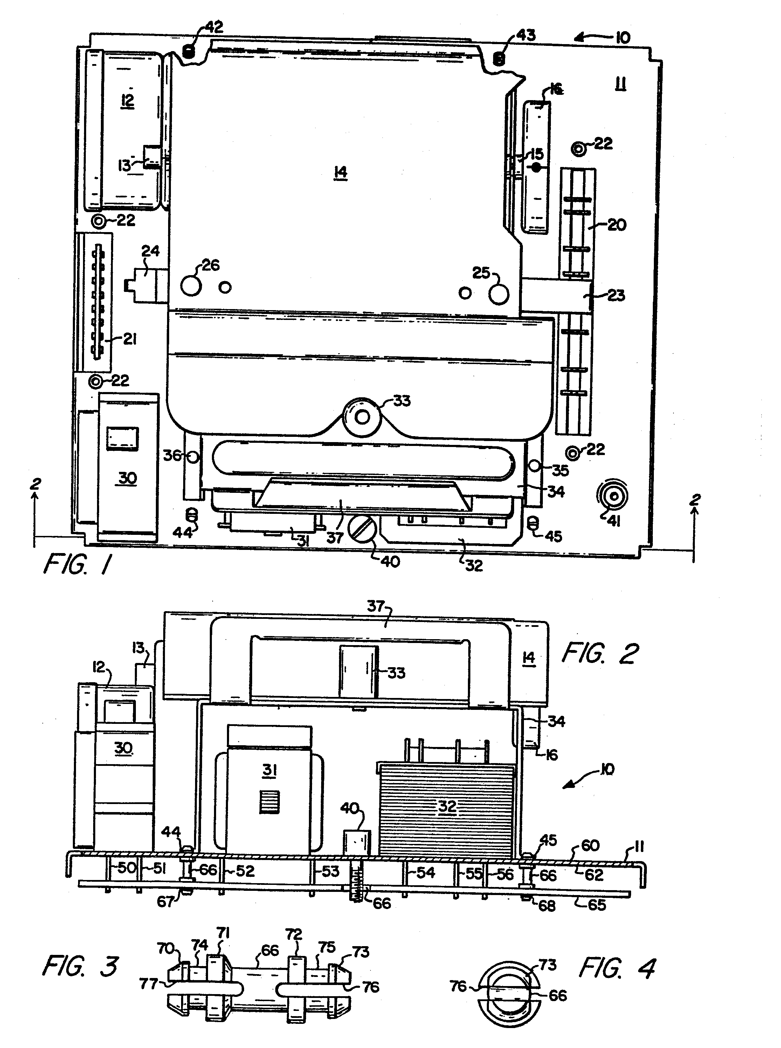

(57) Mounting posts (66) are utilized to retain a printed wiring board (65) beneath a chassis (11) where the chassis supports a plurality of electrical and mechanical components (12, 14, 20, 21, 31, 32). The mounting posts (66) pass through holes (44, 45; 67, 68) in the chassis and the printed wiring board, and allow for a generally parallel relationship between the printed wiring board and the chassis. The design of the mounting posts and the holes allows for lateral movement of the printed wiring board to provide for a stress-free alignment of the printed wiring board and electrical connection means (50-56) extending from the components on the chassis. The design of the mounting posts also allows for an electrically insulating material which can withstand the high temperatures of a wave-soldering process (Figure 2).

FIG. 2

Croydon Printing Company Ltd

## Electrical Apparatus

The present invention relates to an electrical apparatus according to the preamble of Claim 1. Certain electrical control apparatus which utilize heavy electrical and mechanical components are constructed with a rigid chassis to support the components, and the chassis is then wired by a form of wiring harness to interconnect the components. This type of structure involves an extensive amount of hand labor in the interconnection of the wiring harness and electrical components.

It has been considered desirable to mount the electrical components directly on a printed wiring board to eliminate all of the handwiring which is entailed in the previously described structure. This mounting has been found to be impractical, as the weight of the components makes the use of a conventional printed wiring board unacceptable from a mechanical strength point of view.

Therefore, it is the object of the present invention to provide an electrical apparatus which may be manufactured less costly and simpler than the prior art devices. This object is achieved according to the characterizing features of claim 1. Further advantageous embodiments of the inventive apparatus may be taken from the subclaims.

An electrical control apparatus, shown as a fuel burner control sequencer, is constructed with a chassis for mounting heavy components including the electrical components. The chassis is used to mount a plurality of components, both electrical and mechanical, that are of a substantial size and weight. The electrical components have semirigid connecting means extending therefrom beneath the chassis to a side opposite from the mounted components. A printed wiring board is then supported from the chassis by a plurality of mounting posts. The mounting posts interconnect the chassis and the printed wiring board by being snapped into holes in the chassis and printed wiring board which are substantially in alignment with one another. The mounting posts are sufficiently loose in their lateral engagement with the chassis and the printed wiring board so as to allow the printed wiring board to move freely in a lateral direction, while being mounted generally parallel to the chassis. The electrical connection means extend through holes in the printed wiring board so that connection with the circuitry on the printed wiring board can be accomplished by conventional soldering techniques while the board is held in this stress-free alignment.

Attempts to mount the printed wiring board directly to electrical connection means projecting from electrical components on a chassis create mechanical stresses at the interconnection between the printed wiring board and the electrical connection means, and these connections are apt to break during normal usage, vibration, and shipment of the device. By the use of the mounting posts to hold the generally parallel relationship between the chassis and the printed wiring board in the stress-free alignment, this problem is overcome.

Under reference to the figures of the attached drawing an embodiment of the inventive apparatus shall be further described, where:

Figure 1 is a top view of an electrical control apparatus;

Figure 2 is a cross section of Figure 1 taken along lines 2-2;

Figure 3 is a side view of a single mounting post, and;

Figure 4 is an end view of Figure 3.

In Figure 1 there is disclosed a top view of a flame safeguard burner sequencer 10. The particular sequencer disclosed at 10 is typical of a family of devices known as the R4140 as sold by Honeywell Inc. The sequencer 10 has a metal chassis 11 upon which are mounted a number of mechanical and electrical components that are quite heavy. A timer motor is disclosed at 12 that drives a shaft 13 which in turn is connected to a plurality of cam operated switches (not shown) which are beneath a cover generally disclosed at 14. The shaft 13 is extended at 15 to mount a knob or indicator wheel 16 that can be used to turn the cam operated switches manually, and which is used as an indicator of the position of the switches.

Also mounted in the chassis 11 are a pair of connector plugs 20 and 21 which are held in place by a plurality of rivets 22. The socket 20 is used to mount an amplifier (not shown), while the socket 21 is used to mount a prepurge timing device (not shown). A pair of retention tabs 23 and 24 are riveted at 25 and 26 to the cover 14 and are used to hold equipment into the sockets 20 and 21 when the device is installed. The chassis 11 further supports a safety switch disclosed at 30, a relay 31, and a transformer 32. The safety switch 30, the relay 31, and the transformer 32 are all of substantial size and weight and are conventional components used in the sequencer 10. In addition to the relay 31, a number of other relays may be present beneath the cover 14. The cover 14 is aligned by a post 33 that is mounted into a U-shaped frame 34 that is attached at 35 and 36 to the chassis 11. The U-shaped frame further has a handle 37 that forms part of the bight of the U-shaped frame 34. The handle 37 is a convenient way of installing the sequencer 10 which is of substantial weight.

Placed through the chassis 11 is a retention bolt 40 that is used to secure the sequencer 10 on a subbase (not shown) when the device is installed in a flame safeguard control system. Also shown through the chassis 11 is a flame current plug 41 which is convenient for measuring electrical characteristics in the device. The chassis 11 is completed by providing four holes 42, 43, 44, and 45 which are important to the present invention. The four holes 42, 43, 44, and 45 are used to retain mounting post means that will be described in connection with Figures 2 through 4.

In Figure 2 an elevation taken along lines 2-2 of Figure 1 discloses the sequencer 10 and the chassis 11, along with some of the key elements that are mounted on the chassis 11. The safety switch 30 is again disclosed, and it further has a pair of electrical connection means disclosed at 50 and 51. The electrical connection means 50 and 51 are semirigid electrical conductors projecting from the safety switch 30. The relay 31 is shown with a pair of typical electrical connection means 52 and 53 which are similar to the electrical connection means 50 and 51. The transformer 32 is disclosed as having three electrical connection means 54, 55, and 56. These are semirigid electrical connectors of which only some have been shown, by way of example.

Mounted parallel to the second side 62 of the chassis 11 is a printed wiring board 65 that has a plurality of openings that accept the electrical connection means 50-56 so that the printed wiring board 65 can be soldered to the electrical connection means. Any number of openings in the printed wiring board are provided that are necessary for interconnection. Also, projecting through the printed wiring board 65 is the bolt 40 through a hole 66 so that the sequencer 10 can be secured on the subbase (not shown).

Four mounting post means 66 are used to hold the printed wiring board to the chassis 11. The mounting post means 66 (only two of which are shown in Figure 2) pass through holes 44 and 45 in the chassis 11 and into holes 67 and 68 in the printed wiring board 65. It will be understood that a pair of mounting post means 66 are provided between the holes 42 and 43 of Figure 1 and the printed wiring board at a point directly opposite the holes 42 and 43. The mounting post means retain the printed wiring board in a generally parallel configuration to the second side 62 of the chassis 11, while allowing lateral movement of the printed wiring board 65 to allow a stress-free alignment of the wiring connection holes in the printed wiring board and the electrical connection means 50-56. The mounting post means 66 will be described in detail in connection with Figures 3 and 4, but it is understood that they have retention means that allow them to loosely hold the printed wiring board 65 to the chassis 11 so that lateral movement is allowed thereby accomplishing stress-free alignment.

In Figures 3 and 4 there is disclosed in detail the mounting post means 66. The mounting posts 66 are of an electrically insulating material which can also withstand the high temperatures of a wave-soldering process. In Figure 3 a side view of the post means 66 is disclosed. The post means 66 has a plurality of ridges 70, 71, 72, and 73. The ridges 70-73 define a pair of recesses 74 and 75. It will be noted that the ridges 70 and 73 are each tapered to allow easy access into the holes 42-45. Also, a pair of slots 76 and 77 are provided so that the ridges 70 and 73 can compress conveniently to pass through an appropriately sized hole and snap into a retained position. The recesses 74 and 75 are designed to snap through the chassis 11 and the printed wiring board 65, and lock the printed wiring board to the second side 62 of the chassis 11 in a generally parallel relationship to the side 62. This relationship allows for sufficient lateral movement to allow a stress-free alignment of the terminals 50-56 in holes in the printed wiring board 65. After the device has been assembled, conventional soldering techniques, such as wave soldering, complete the electrical connection between the printed wiring board 65 and the terminals 50-56. This soldering operation takes place without stress and allows the soldered joints to remain reliable during the normal handling, use, and operation of the sequencer. The mounting posts will withstand the high temperatures encountered through a wave-soldering process.

Claims:

1. Electrical apparatus, including a chassis (11) for mounting a plurality of components (12, 14, 20, 21, 31, 32), in particular electrical components with said components being mounted upon a first side (60) of said chassis and having electrical connecting means (50-56) extending through said chassis and from a second side (62) of said chassis for connection into an electrical circuit, c h a r a c t e r i z e d    b y :
a printed wiring board (65) forming at least a part of said electrical circuit and having wiring connection holes into which said electrical connection means (50-56) extend; and
flexible mounting posts (66) retaining said chassis (10) and said printed circuit board (65) generally parallel to each other and allowing a limited lateral movement.

2. Apparatus according to claim 1,  c h a r a c t e r - i z e d    i n    t h a t   said chassis (11) and said printed wiring board (65) each have a plurality of mounting holes (44, 45; 67, 68) substantially in alignment when said printed wiring board is in place generally parallel to said second side (62) of said chassis (11) with said mounting posts (66) being placed in said mounting holes to retain said chassis and said printed wiring board in a stress-free alignment.

3. Apparatus according to claim 2,  c h a r a c t e r - i z e d    i n    t h a t   said chassis (11) is a metal chassis that is rigid and supportive of said plurality of components (30-32) and said printed wiring board (65).

4. Apparatus according to claim 3,  c h a r a c t e r - i z e d    i n    t h a t   said mounting posts (66) are of plastic with annular ridges (71, 72), that abut said chassis (11) and said printed wiring board (65) to retain said stress-free alignment.

**0136568**

5. Apparatus according to claim 4, c h a r a c t e r - i z e d   i n   t h a t   said posts (66) further have slots (76, 77) along a center axis of said posts with said slots extending from each end of said posts through said annular ridges (71, 72).

6. Apparatus according to claim 5, c h a r a c t e r - i z e d   i n   t h a t   said ends of said posts (66) are compressible as a result of said slots (76, 77) to allow easy entry into said holes in said chassis (11) and said printed wiring board (65).

FIG. 1

FIG. 2

FIG. 3

FIG. 4

0136568

1/1